# EUROPÄISCHE PATENTSCHRIFT

(11) **EP 3 676 913 B1**
(45) Veröffentlichungstag und Bekanntmachung des Hinweises auf die Patenterteilung: **13.03.2024**
(21) Anmeldenummer: 18750201.8
(22) Anmeldetag: 03.08.2018
(51) Int. Cl.: H05K 3/30, H05K 3/32, H01R 12/58, H01R 43/02, H01R 4/02

(54) **EINPRESSPIN FÜR EINE ELEKTRISCHE KONTAKTIERANORDNUNG**
PRESS-IN PIN FOR AN ELECTRICAL CONTACTING ASSEMBLY
BROCHE À PRESSION CONÇUE POUR UN ENSEMBLE DE MISE EN CONTACT E LECTRIQUE

(30) Priorität: 28.08.2017 DE 102017215026
(43) Veröffentlichungstag der Anmeldung: 08.07.2020
(73) Patentinhaber: Robert Bosch GmbH, 70442 Stuttgart (DE)
(72) Erfinder: HACHTEL, Andreas, 70771 Leinfelden-Echterdingen (DE); KLETT, Gustav, 72116 Moessingen (DE); LUDWIG, Ronny, 72770 Reutlingen (DE); SCHUERER, Martin, 72768 Reutlingen (DE)
(86) Internationale Anmeldenummer: PCT/EP2018/071187
(87) Internationale Veröffentlichungsnummer: WO 2019/042708

(56) Entgegenhaltungen:
- EP-A1- 2 811 051
- DE-A1- 10 349 584
- DE-A1-102014 117 410
- US-A1- 2011 031 301
- US-A1- 2014 210 110

## Beschreibung

Die Erfindung geht aus von einem Einpresspin für eine elektrische Kontaktieranordnung nach Gattung des unabhängigen Patentanspruchs 1. Gegenstand der vorliegenden Erfindung sind auch eine elektrische Kontaktieranordnung mit einem solchen Einpresspin sowie ein Verfahren zum Fügen eines Einpresspins und einer metallisierten Durchkontaktierung.

Aus dem Stand der Technik sind Leiterplatteneinpresspins mit einer überschaubaren Anzahl an unterschiedlichen Beschichtungsvarianten bekannt. Man unterscheidet dabei in zinnbasierte Beschichtungsvarianten und zinnfreie Beschichtungsvarianten. Je nach der zu erwartenden Belastung der elektromechanischen Verbindung zwischen dem Einpresspin und metallisierter Durchkontaktierung werden diese unterschiedlichen Schichtsysteme eingesetzt. Die mechanische Verbindung zwischen Einpresspin und Durchkontaktierung basiert auf einem Kraftschluss, einem Formschluss und einem Materialschluss. Der Kraftschluss wird durch die Federkennlinie des elastischen Einpresspins, somit durch dessen Federgeometrie, das Verhältnis von Durchkontaktierungsdurchmesser zur Breite des Einpresspins sowie der mechanischen Eigenschaften der Grundmaterialien des Einpresspins (E-Modul, Textur der Bronze) sowie des Leiterplattenbasismaterials (in erster Linie Druckspannungsfestigkeit) bestimmt. Der Formschluss wird durch die Geometrie der im direkten Kontakt befindlichen Anlageflächen zwischen Einpresspin und metallisierter Durchkontaktierung sowie deren topografische Eigenschaften (z.B. Rauheit) bestimmt. Materialschluss entsteht ausschließlich durch die Ausbildung von Diffusionsbrücken zwischen der Oberfläche des Einpresspins und der metallisierten Durchkontaktierung. Dafür sind zinnbasierte Oberflächen zumindest einseitig notwendig. Durch die beim Falten des Einpresspins entstandenen Druckspannungen in der metallisierten Durchkontaktierung und ein entsprechendes Diffusionsgefälle des Zinns auf dem Einpresspin zum Kupfer bzw. zur intermetallischen Kupfer-Zinn-Oberfläche der metallisierten Durchkontaktierung diffundieren beide Oberflächen ineinander. Es entsteht schon nach sehr kurzer Zeit eine sogenannte gasdichte Verbindung. Diese materialschlüssige Verbindung sorgt für eine höhere Belastbarkeit der elektromechanischen Verbindung und wird überall dort eingesetzt, wo ausschließlich kraft- und formschlussbasierte Einpressverbindungen für die gestellte Anforderung nicht ausreichend sind. Typische zinnbasierte Oberflächensysteme beruhen auf dem Kraft-, Form- und Materialschluss zwischen Einpresspin und metallisierter Durchkontaktierung. Sehr weit verbreitet sind immer noch Beschichtungen auf Zinn-Blei-Basis (z.B. SnPb5) mit einer Unterschicht aus Nickel, welche aber aufgrund des Bleianteils immer mehr zurückgedrängt werden. Ebenso verbreitet sind dünne Beschichtungen aus reinstem Zinn mit einer Unterschicht aus Nickel. Neue Oberflächensysteme kombinieren Zinn mit Silber. Auch diese Zinn-Silber-Schichten bzw. Silber-Zinn-Schichten werden auf eine Unterschicht aus Nickel aufgebracht.

Zinnfreie Oberflächensysteme basieren in der Regel nur Kraft- und Formschluss zwischen Einpresspin und metallisierter Durchkontaktierung. Ebenso sehr weit verbreitet sind reine Nickeloberflächen als Mattnickelschicht oder als Sandwich-Schichtaufbau. Beim Nickel-Sandwich-Schichtaufbau wird eine Glanznickelschicht über einer Mattnickelschicht abgeschieden. Nickeloberflächen werden häufig mit reibungsmindernden Schichten sogenannten Lubricants beschichtet, z.B. auf Thiolbasis oder mittels Perfluorpolyethern. Ein weiteres bekanntes zinnfreies Oberflächensystem basiert auf Indium.

Die im Stand der Technik beschriebenen Oberflächen von Einpresspins haben teilweise sehr entscheidende Nachteile. Aufgrund der hohen mechanischen Spannungen neigen zinnbasierte Oberflächen stark zum Wachstum von Whiskern, insbesondere die Reinzinnoberflächen sind davon betroffen. Aber auch auf Zinn-Blei-Schichten, Zinn-Silber-Schichten oder auf Indium basierte Oberflächen bilden Whisker aus. Aufgrund der Beimischung anderer Metalle werden aber deutlich weniger Whisker ausgebildet. Diese Zinn-Whisker können zu Kurzschlüssen führen. Ein weiterer Nachteil der heutigen Einpresstechnik ist die Mechanik selbst. Um hohe Festigkeiten der elektromechanischen Verbindung erzielen zu können, müssen die Pins eine entsprechend hohe Druckspannung in die Leiterplatte einbringen. Dadurch entstehen typische Einpresstechnikfehler, wie beispielsweise eine zu starke Deformation der Kupferlagen, Jet-Effekt, Hülsenrisse sowie die Erzeugung elektrisch leitfähiger Partikel (Abrieb). Alle diese Fehlerarten sind u.a. auch in der DIN-EN 60352-5 beschrieben.

Für eine mechanisch hochbelastbare Verbindung zwischen Einpresspin und PTH sind zusammenfassend also entweder hohe Druckspannungen in die Leiterplatte mit hoher Fehlerwahrscheinlichkeit und/oder auf Zinn basierende Pinoberflächen mit Whisker-Risiko erforderlich.

Aus der DE 103 49 584 B4 ist ein Einpresspin für eine elektrisch leitende Verbindung zwischen dem Einpresspin und einer elektrisch leitenden Buchse bekannt. Der Einpresspin und die Buchse sind so ausgestaltet, dass eine zwischen dem Einpresspin und der Buchse gebildete Kontaktfläche durch plastische Verformung beim Einpressvorgang gebildet ist. Die Kontaktfläche am Einpresspin und/oder an der Buchse ist durch eine äußere Schicht gebildet, welche auf eine Diffusionssperrschicht aufgebracht ist und eine Dicke zwischen 0,1 bis 0,8µm, vorzugsweise bis 0,6µm aufweist. Die äußere Schicht ist beispielsweise aus Silber, einer Silberlegierung, Gold, einer Goldlegierung, Zinn oder einer Zinnlegierung gebildet.

Aus der US 2011/031301 A1 ist ein eine durch eine exotherme Reaktion erzeugte Lötverbindung zwischen zwei Leitern einer elektrischen Maschine bekannt.

Aus der US 2014/210110 A1 ist ein eine durch eine exotherme Reaktion erzeugte Lötverbindung zwischen zwei mikroelektrischen Bauelementen bekannt.

Aus der DE 10 2014 117 410 A1 ist ein elektrisches Kontaktelement mit einem Grundkörper und einer den Grundkörper zumindest abschnittsweise bedeckenden Beschichtung bekannt. Die Beschichtung umfasst eine innere Schicht und eine äußere Schicht, wobei die innere Schicht auf dem Grundkörper (11) und die äußere Schicht auf der inneren Schicht aufgebracht ist und zumindest abschnittsweise eine Oberfläche des elektrischen Kontaktelements bildet. Die innere Schicht ist aus Zinn und die äußere Schicht ist aus Silber gebildet, wobei die äu-ßere Schicht eine Dicke von 50nm bis 5,0µm aufweist.

Aus der EP 2 811 051 A1, die den Oberbegriff des unabhängigen Anspruchs 1 offenbart, sind ein gattungsgemäßer Einpresspin und eine korrespondierende elektrische Kontaktieranordnung, mit einem solchen Einpresspin bekannt. Der Einpresspin umfasst einen elastischen Einpressbereich und eine elektrisch leitende Beschichtung mit einem Zinnanteil. Die Beschichtung umfasst eine auf den Einpresspin aufgebrachte Multischicht und eine auf die Multischicht aufgebrachte erste Kontaktschicht. Die elektrische Kontaktieranordnung umfasst einen solchen Einpresspin und eine metallisierte Durchkontaktierung, welche in ein Loch einer Leiterplatte eingebracht ist und eine Kontaktfläche für den elastischen Einpressbereich und die elektrisch leitende Beschichtung ausbildet. Der Einpresspin ist in die metallisierte Durchkontaktierung eingepresst, so dass zwischen der ersten Kontaktschicht des Einpresspins und einer zweiten Kontaktschicht der metallisierten Durchkontaktierung eine elektrisch leitende Pressverbindung ausgebildet ist.

### Offenbarung der Erfindung

Die Erfindung wird durch einen Einpresspin nach Anspruch 1, eine elektrische Kontaktieranordnung nach Anspruch 6 und ein Verfahren nach Anspruch 9 definiert.

Der Einpresspin für eine elektrische Kontaktieranordnung mit den Merkmalen des unabhängigen Patentanspruchs 1 hat den Vorteil, dass hoch belastbare Verbindungen zwischen Einpresspin und metallisierter Durchkontaktierung mit sehr niedrigen Druckspannungen sowie zinnfreien Oberflächen ausgebildet werden können. Ausführungsformen des erfindungsgemäßen Einpresspins können ein beliebiges Design mit einem reaktiven Multischichtsystem als Oberfläche aufweisen und über ein entsprechendes Fügeverfahren mit der metallisierten Durchkontaktierung in der Leiterplatte verbunden werden.

Ausführungsformen der Erfindung beschreiben eine auf Materialschluss basierende, mechanisch hochbelastbare Verbindung zwischen dem Einpresspin und der metallisierten Durchkontaktierung auf Basis einer neuartigen zinnfreien Beschichtung des Einpresspins ohne sämtliche oben aufgeführten Nachteile der aus dem Stand der Technik bekannten Einpresspins, d.h. ohne Bildung von Zinn-Whisker und ohne mechanische Beschädigungen durch einen zu hohen Druckspannungseintrag in die Leiterplatte bzw. die metallisierte Durchkontaktierung während des Fügeprozesses.

Ausführungsformen der vorliegenden Erfindung stellen einen Einpresspin für eine elektrische Kontaktieranordnung zur Verfügung, welcher einen elastischen Einpressbereich und eine elektrisch leitende Beschichtung aufweist. Hierbei umfasst die Beschichtung eine auf den Einpresspin aufgebrachte reaktive Multischicht und eine auf die reaktive Multischicht aufgebrachte erste Kontaktschicht. Das bedeutet, dass die im Stand der Technik beschriebenen Oberflächen der Einpresspins durch die reaktive Multischicht und die erste Kontaktschicht, welche beispielsweise aus Kupfer besteht, ersetzt werden.

Zudem wird eine elektrische Kontaktieranordnung mit einem solchen Einpresspin, welcher einen elastischen Einpressbereich und eine elektrisch leitende Beschichtung aufweist, und einer metallisierten Durchkontaktierung vorgeschlagen, welche in ein Loch einer Leiterplatte eingebracht ist und eine Kontaktfläche für den elastischen Einpressbereich und die elektrisch leitende Beschichtung ausbildet. Der Einpresspin ist in die metallisierte Durchkontaktierung einschoben ist. Zwischen der ersten Kontaktschicht des Einpresspins und einer zweiten Kontaktschicht der metallisierten Durchkontaktierung bildet sich eine materialschlüssige Verbindung aus, welche aufgrund einer exothermen Reaktion der aktivierten reaktiven Multischicht entsteht.

Des Weiteren wird ein Verfahren zum Fügen eines solchen Einpresspins und einer metallisierten Durchkontaktierung vorgeschlagen, welche in ein Loch einer Leiterplatte eingebracht ist. Der Einpresspin wird in die metallisierte Durchkontaktierung eingeschoben, bis eine gewünschte Tiefe erreicht ist. Anschließend wird die reaktive Multischicht der Beschichtung des Einpresspins durch einen Energieimpuls aktiviert, welcher eine exotherme Reaktion der reaktiven Multischicht auslöst. Durch die exotherme Reaktion erzeugte Wärme schmilzt die benachbarte erste Kontaktschicht des Einpresspins und die zweite Kontaktschicht der metallisierten Durchkontaktierung auf und verschweißt diese miteinander zu der materialschlüssigen Verbindung. Dadurch kann ohne hohe Druckspannungen und ohne mechanischen Stress und ohne Bildungsrisiko von Zinn-Whiskern eine hochbelastbare Verbindung zwischen Einpresspin und metallisierter Durchkontaktierung geschaffen werden. Durch den extrem kurzen Temperatureintrag ergibt sich in vorteilhafter Weise keine signifikante Gefügeänderung im Metall. Durch die nachfolgende exotherme Reaktion können die Fügekräfte beim "Einpressen" des Einpresspins in die metallisierte Durchkontaktierung deutlich reduziert werden. So ist es ausreichend, den Einpresspin nur in die metallisierte Durchkontaktierung einzuschieben. Dadurch können die Druckspannungen in die metallisierte Durchkontaktierung und in die Leiterplatte auf ein notwendiges Minimum reduziert und sämtliche bekannte Fehler der Leiterplatteneinpresstechnik in vorteilhafter Weise sicher vermieden werden. Durch die stark reduzierten Fügekräfte ergibt sich eine größere Designfreiheit bei der Anbindung des Einpresspins am Stanzgitter. Dafür muss zusätzlich zum Einpressen der Einpresspins in die metallisierten Durchkontaktierungen der Leiterplatte ein nachfolgender Prozess zum Zünden der reaktiven Multischichten durchgeführt werden.

Durch die in den abhängigen Ansprüchen aufgeführten Maßnahmen und Weiterbildungen sind vorteilhafte Verbesserungen des im unabhängigen Patentanspruch 1 angegebenen Einpresspins für eine elektrische Kontaktieranordnung Vorrichtung, der im unabhängigen Patentanspruch 6 angegebenen elektrischen Kontaktieranordnung mit einem solchen Einpresspin und des im unabhängigen Patentanspruch 9 angegebenen Verfahrens zum Fügen eines solchen Einpresspins und einer metallisierten Durchkontaktierung möglich.

Besonders vorteilhaft ist, dass die reaktive Multischicht auf eine effektive Einpresslänge des elastischen Einpressbereichs aufgebracht werden kann. Die reaktive Multischicht kann beispielsweise aus mindestens zwei unterschiedlichen metallischen Materialien aufgebaut werden, welche alternierend in der richtigen Phase zueinander auf dem Einpresspin abgeschieden werden. So kann der Einpresspin im Bereich der effektiven Einpresslänge selektiv mit der reaktiven Multischicht beschichtet werden. Die beiden unterschiedlichen metallischen Materialien können bei entsprechender Aktivierung in eine kurzzeitige exotherme Reaktion treten. Da Einpresspins in sehr großen Stückzahlen verarbeitet werden, sind die in der Literatur beschriebenen gängigen Sputterverfahren mit Abscheideraten zwischen 2-6µm/h nicht anwendbar. Einpresspins werden in der Regel in Stanzbändern Reel-to-Reel hergestellt und in Bandgalvanikanlagen mittels wässriger Elektrolyten elektrochemisch beschichtet. Diese Beschichtung erfolgt zumeist selektiv, da die Einpresspins sehr häufig eine andere Oberfläche benötigen als der Rest des Stanzgitters, der häufig den Kontaktstift bzw. Steckerstift einer Kundenschnittstelle darstellt. Da sich nicht alle Metalle aus wässrigen Elektrolyten abscheiden lassen (z.B. Aluminium), reaktive Multischichtsysteme aber häufig auf Aluminium basieren, kann die Abscheidung der reaktiven Multischicht mittels spezieller Elektrolyte aus einer aprotischer Lösung, wie beispielsweise Toluol, bei erhöhten Temperaturen erfolgen. Dafür kann vorzugweise eine vollständig geschlossene Beschichtungsanlage eingesetzt werden, da die Abscheidung unter Inertgasatmosphäre stattfindet.

In vorteilhafter Ausgestaltung des Einpresspins kann die reaktive Multischicht Aluminium als erstes metallisches Material und Nickel als zweites metallisches Material aufweisen. Als erste Kontaktschicht kann beispielsweise Kupfer aufgebracht werden.

In vorteilhafter Ausgestaltung der elektrischen Kontaktieranordnung können Abmessungen und Federeigenschaften des elastischen Einpressbereichs des Einpresspins so auf Abmessungen der metallisierten Durchkontaktierung abgestimmt werden, dass der elastische Einpressbereich eine Querkraft auf die metallisierte Durchkontaktierung erzeugt, welche kleiner als 25N/mm² ist. Die zweite Kontaktschicht der metallisierten Durchkontaktierung kann beispielsweise Kupfer aufweisen.

Die Herstellung der Einpresspins kann in vorteilhafter Weise identisch den heutigen Stanzprozessen erfolgen. Neu ist die Dimensionierung der metallisierten Durchkontaktierung in Relation zur Breite des Einpresspins bzw. zu dessen Federkennlinie. Während bei der konventionellen Einpresstechnik sehr hohe mechanische Spannungen (i.d.R. >>150MPa (150N/mm²)) zwischen Einpresspin und metallisierter Durchkontaktierung erforderlich sind, kann die metallisierte Durchkontaktierung der Leiterplatte für die Ausführung des erfindungsgemäßen Verfahren zum Fügen eines erfindungsgemäßen Einpresspins mit reaktiver Multischicht und der metallisierten Durchkontaktierung jetzt so dimensioniert werden, dass der Einpresspin nur noch geringe mechanische Spannungen (< 20N/mm² (20MPa)) in die metallisierte Durchkontaktierung einbringt. Sämtliche im Stand der Technik beschriebenen Nachteile (Deformationen, Jet-Effekt, Risse, Späne usw.) beim Fügen des Einpresspins und der metallisierten Durchkontaktierung sind somit in vorteilhafter Weise nicht mehr existent. Nach dem vergleichsweise leichten Einpressen bzw. Einschieben des Einpresspins in die entsprechende metallisierte Durchkontaktierung der Leiterplatte müssen die reaktiven Multischichten in eine exotherme Reaktion gebracht werden. Dafür ist ein "Zündimpuls" notwendig. Dieser kann beispielsweise als elektrischer Impuls oder mit einem Laser als Laserimpuls erzeugt werden. Da nach dem Einpressvorgang eine Spitze des Einpresspins aus der Leiterplatte herausragt, kann über einen gezielten Laserimpuls auf die Pinspitze die exotherme chemische Reaktion einfach gestartet werden. Alternativ kann die exotherme chemische Reaktion über einen gezielten elektrischen Impuls gestartet werden, welcher über eine Tastnadel in die Spitze des Einpresspins eingeleitet wird. Dadurch wird Energie in Form von Wärme freigesetzt, welche die Nachbarbereiche neben der "Zündstelle" aktiviert. Es entsteht eine thermische Welle durch die gesamte reaktive Multischicht des Einpresspins hindurch. Die exotherm erzeugte Wärme reicht aus, um andere Metalle aufzuschmelzen, welche sich im direkten Kontakt befinden. Dadurch wird ein Verschweißen der metallisierten Durchkontaktierung mit dem Einpresspin realisiert, ohne wesentlichen Temperatureintrag in die Leiterplatte, da die Reaktion extrem schnell abläuft. Es wird somit eine hochbelastbare und sogenannte gasdichte Verbindung zwischen dem Einpresspin und der metallisierten Durchkontaktierung geschaffen. Da die metallisierten Durchkontaktierungen von Leiterplattenbohrungen in der Regel auf Kupfer basieren, würde sich eine dünne Verkupferung der Einpresspins oberhalb der reaktiven Multischicht anbieten. Diese dünne Kupferschicht als erste Kontaktschicht verschmilzt mit der Kupferschicht als zweite Kontaktschicht der metallisierten Durchkontaktierung. Kupfer hat einen Schmelzpunkt von 1085°C. Reaktive Multischichten auf Basis von alternierenden Nickel-Aluminium-Schichten haben eine adiabatische Reaktionstemperatur von 1639°C, also deutlich darüber. Kupferschichten lassen sich im Neuzustand zudem hervorragend mit hauchdünnen organischen Beschichtungen passivieren und gegen Oxidation schützen. Beide Passivierungen dampfen bei hohen Temperaturen ab und stören die Kupferverschmelzung zwischen Einpresspin und metallisierter Durchkontaktierung nicht. Da durch den Wechsel auf organische Beschichtungen der zweiten Kontaktschicht der metallisierten Durchkontaktierung auf die heute übliche chemische Verzinnung verzichtet werden kann, ergibt sich eine Kostenreduktion bei der Leiterplattenherstellung.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Schnittdarstellung auf ein Ausführungsbeispiel eines erfindungsgemäßen Einpresspins für eine elektrische Kontaktieranordnung.
Fig. 2 zeigt eine Detaildarstellung II aus Fig. 1.
Fig. 3 zeigt eine schematische Schnittdarstellung eines Ausführungsbeispiels einer erfindungsgemäßen elektrischen Kontaktieranordnung mit dem Einpresspin aus Fig. 1.
Fig. 4 zeigt eine Schnittdarstellung entlang der Schnittlinie IV - IV aus Fig. 2.
Fig. 5 zeigt eine Detaildarstellung V aus Fig. 4 vor der Aktivierung einer reaktiven Multischicht des Einpresspins.
Fig. 6 zeigt eine Detaildarstellung VI aus Fig. 4 nach der Aktivierung der reaktiven Multischicht des Einpresspins.

### Ausführungsformen der Erfindung

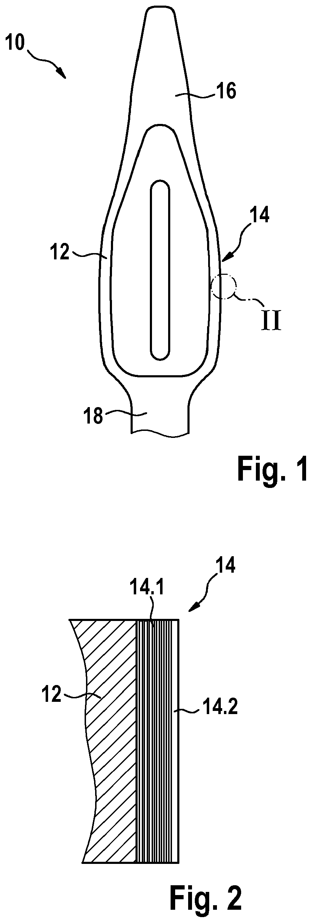

Wie aus Fig. 1 bis 6 ersichtlich ist, umfasst das dargestellte Ausführungsbeispiel eines erfindungsgemäßen Einpresspins 10 für eine elektrische Kontaktieranordnung 1 einen elastischen Einpressbereich 12 und eine elektrisch leitenden Beschichtung 14. Hierbei umfasst die Beschichtung 14 eine auf den Einpresspin 10 aufgebrachte reaktive Multischicht 14.1 und eine auf die reaktive Multischicht 14.1 aufgebrachte erste Kontaktschicht 14.2.

Im dargestellten Ausführungsbeispiel des Einpresspins 10 ist die reaktive Multischicht 14.1 auf eine effektive Einpresslänge des elastischen Einpressbereichs 12 aufgebracht. Die reaktive Multischicht 14.1 weist im dargestellten Ausführungsbeispiel Aluminium als erstes metallisches Material und Nickel als zweites metallisches Material auf. Die als Nickel-Aluminium-Schichtstapel ausgebildete reaktive Multischicht 14.1 weist eine freiwerdende Bindungsenthalpie von - 59kJ/mol auf und erzeugt eine adiabatische Reaktionstemperatur von 1639°C. Selbstverständlich kann die reaktive Multischicht 14.1 auch aus mindestens zwei anderen unterschiedlichen metallischen Materialien aufgebaut werden, welche alternierend in der richtigen Phase zueinander auf dem Einpresspin 10 abgeschieden werden. Die erste Kontaktschicht 14.2 des Einpresspins 10 besteht im dargestellten Ausführungsbeispiel aus Kupfer. Der elastische Einpressbereich 12 ist zwischen einer Spitze 16 und einem Kontaktstift 18 bzw. Steckerstift des Einpresspins angeordnet.

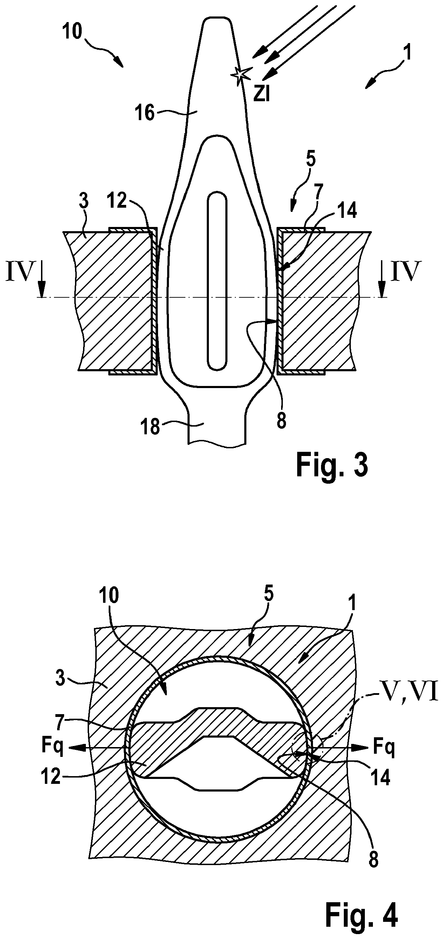

Wie aus Fig. 3 bis 6 weiter ersichtlich ist, umfasst das dargestellte Ausführungsbeispiel einer erfindungsgemäßen elektrischen Kontaktieranordnung 1 den Einpresspin 10, welcher den elastischen Einpressbereich 12 und die elektrisch leitende Beschichtung 14 aufweist, und eine metallisierte Durchkontaktierung 7, welche in ein Loch 5 einer Leiterplatte 3 eingebracht ist und eine Kontaktfläche 8 für den elastischen Einpressbereich 12 und die elektrisch leitenden Beschichtung 14 ausbildet. Der Einpresspin 10 ist in die metallisierte Durchkontaktierung 7 eingeschoben. Zwischen der ersten Kontaktschicht 14.2 des Einpresspins 10 und einer zweiten Kontaktschicht 8.1 der metallisierten Durchkontaktierung 7 ist eine materialschlüssige Verbindung 9 ausgebildet, welche aufgrund einer exothermen Reaktion der aktivierten reaktiven Multischicht 14.1 entsteht.

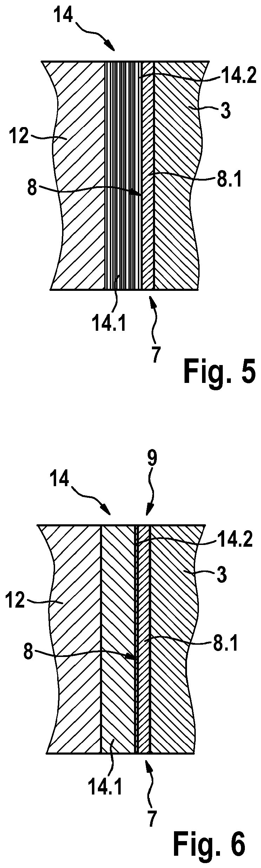

Wie aus Fig. 3, 4 und 5 weiter ersichtlich ist, liegt der Einpresspin 10 an seinen Flanken an der metallisierten Durchkontaktierung 7 an und die dünne Verkupferung des Einpresspins 10 steht als erste Kontaktschicht 14.2 in direktem Kontakt mit dem Kupfer der zweiten Kontaktschicht 8.1 der metallisierten Durchkontaktierung 7. Bei der Darstellung gemäß Fig. 5 ist die reaktive Multischicht 14.1 noch nicht durchreagiert. Wie aus Fig. 4 weiter ersichtlich ist, wird der Einpresspin 10 beim Fügen kaum verformt, da im Gegensatz zum konventionellen Einpressen nur eine geringe Flächenpressung erforderlich ist. Daher sind Abmessungen (Breite) und Federeigenschaften des elastischen Einpressbereichs 12 des Einpresspins 10 so auf Abmessungen (Durchmesser) der metallisierten Durchkontaktierung 7 abgestimmt, dass der elastische Einpressbereich 12 eine Querkraft Fq auf die metallisierte Durchkontaktierung 7 erzeugt, welche kleiner als 25N/mm² ist.

Zur Durchführung des Verfahrens zum Fügen des Einpresspins 10 und der metallisierten Durchkontaktierung 7 wird der Einpresspin 10 in die metallisierte Durchkontaktierung 7 eingeschoben, bis eine gewünschte Tiefe erreicht ist. Anschließend wird die reaktive Multischicht 14.1 der Beschichtung 14 des Einpresspins 10 durch einen Energieimpuls aktiviert, welcher eine exotherme Reaktion der reaktiven Multischicht 14.1 auslöst. Durch die exotherme Reaktion erzeugte Wärme schmelzt die benachbarte erste Kontaktschicht 14.2 des Einpresspins 10 und die zweite Kontaktschicht 8.1 der metallisierten Durchkontaktierung 7 auf und verschweißt die erste Kontaktschicht 14.2 mit der zweiten Kontaktschicht 8.1 zu der materialschlüssigen Verbindung 9, wie aus Fig. 6 ersichtlich ist. Das bedeutet, dass durch den Energieimpuls die exotherme Reaktion der reaktiven Multischicht 14.1 gestartet wird. An der Kontaktfläche 8 zwischen dem Einpresspin 10 und der metallisierten Durchkontaktierung 7 verschweißen die beiden aneinander liegenden Kupferschichten, d.h. die erste Kontaktschicht 14.2 und die zweite Kontaktschicht 8.1 zu der gasdichten materialschlüssigen Verbindung 9. Im dargestellten Ausführungsbeispiel wird der Energieimpuls als Laserimpuls ZI von einem Laser erzeugt. Alternativ kann der Energieimpuls als elektrischer Impuls erzeugt werden, welcher über eine Tastnadel in die Spitze 16 des Einpresspins 10 eingeleitet wird.

Wie aus Fig. 3 weiter ersichtlich ist, wird der Laserimpuls ZI gezielt in eine Spitze 16 des in die metallisierten Durchkontaktierung 7 eingeschobenen Einpresspins 10 eingeleitet, welche aus der metallisierten Durchkontaktierung 7 herausragt. Dadurch wird Energie in Form von Wärme freigesetzt, welche die Nachbarbereiche neben der "Zündstelle" aktiviert. Es entsteht eine thermische Welle durch den Einpresspin 10 und die gesamte reaktive Multischicht 14.1 der Beschichtung 14 des Einpresspins 10 hindurch. Die exotherm erzeugte Wärme reicht aus, um andere Metalle, welche sich im direkten Kontakt befinden, aufzuschmelzen. Dadurch wird ein Verschweißen der metallisierten Durchkontaktierung 7 mit dem Einpresspin 10 realisiert, ohne wesentlichen Temperatureintrag in die Leiterplatte 3, da die Reaktion extrem schnell abläuft. Es wird somit die hochbelastbare und sogenannte gasdichte Verbindung 9 zwischen dem Einpresspin 10 und der metallisierten Durchkontaktierung 7 geschaffen.

Da Einpresspins 10 in sehr großen Stückzahlen verarbeitet werden, werden Ausführungsformen des erfindungsgemäßen Einpresspins in Stanzbändern Reel-to-Reel hergestellt. Hierbei werden die Kontaktstifte 18 der Einpresspins 10 selektiv in einer ersten Bandgalvanikanlage mittels wässriger Elektrolyten elektrochemisch beschichtet. Die reaktiven Multischichten 14.1 an den elastischen Bereichen 12 der Einpresspins 10 werden beispielsweise in einer zweiten vollständig geschlossenen Beschichtungsanlage mittels spezieller Elektrolyte aus einer aprotischer Lösung, wie beispielsweise Toluol, bei erhöhten Temperaturen abgeschieden, da sich Aluminium als Teil der reaktiven Multischicht 14.1 des dargestellten erfindungsgemäßen Einpresspins 10 nicht aus wässrigen Elektrolyten abscheiden lässt.

## Patentansprüche

1. Einpresspin (10) für eine elektrische Kontaktieranordnung (1), mit einem elastischen Einpressbereich (12) und einer elektrisch leitenden Beschichtung (14), welche eine auf den Einpresspin (10) aufgebrachte reaktive Multischicht (14.1) und eine auf die reaktive Multischicht (14.1) aufgebrachte erste Kontaktschicht (14.2) umfasst, **dadurch gekennzeichnet, dass** die elektrisch leitende Beschichtung (14) zinnfrei ausgeführt ist und die aufgebrachte reaktive Multischicht (14.1) durch einen eine exotherme Reaktion auslösenden Energieimpuls aktivierbar ist, wobei durch die exotherme Reaktion erzeugte Wärme die benachbarte erste Kontaktschicht (14.2) des Einpresspins (10) und die zweite Kontaktschicht (8.1) einer metallisierten Durchkontaktierung (7) aufschmelzen und miteinander zu einer materialschlüssigen Verbindung (9) verschwei-ßen kann.

2. Einpresspin (10) nach Anspruch 1, wobei die reaktive Multischicht (14.1) auf eine effektive Einpresslänge des elastischen Einpressbereichs (12) aufgebracht ist.

3. Einpresspin (10) nach Anspruch 1 oder 2, wobei die reaktive Multischicht (14.1) aus mindestens zwei unterschiedlichen metallischen Materialien aufgebaut ist, welche alternierend auf dem Einpresspin (10) abgeschieden sind.

4. Einpresspin (10) nach Anspruch 3, wobei die reaktive Multischicht (14.1) Aluminium als erste metallisches Material und Nickel als zweites metallisches Material aufweist.

5. Einpresspin (10) nach einem der Ansprüche 1 bis 4, wobei Kupfer als erste Kontaktschicht (14.2) aufgebracht ist.

6. Elektrische Kontaktieranordnung (1) mit einem Einpresspin (10), welcher einen elastischen Einpressbereich (12) und eine elektrisch leitende Beschichtung (14) aufweist, und einer metallisierten Durchkontaktierung (7), welche in ein Loch (5) einer Leiterplatte (3) eingebracht ist und eine Kontaktfläche (8) für den elastischen Einpressbereich (12) und die elektrisch leitenden Beschichtung (14) ausbildet, wobei der Einpresspin (10) in die metallisierte Durchkontaktierung (7) einschoben ist und zwischen einer ersten Kontaktschicht (14.2) des Einpresspins (10) und einer zweiten Kontaktschicht (8.1) der metallisierten Durchkontaktierung (7) eine materialschlüssige Verbindung (9) ausgebildet ist, wobei der Einpresspin (10) nach zumindest einem der Ansprüche 1 bis 5 ausgeführt ist, wobei die materialschlüssige Verbindung (9) aufgrund einer exothermen Reaktion der aktivierten reaktiven Multischicht (14.1) entsteht.

7. Elektrische Kontaktieranordnung (1) nach Anspruch 6, wobei Abmessungen und Federeigenschaften des elastischen Einpressbereichs (12) des Einpresspins (10) so auf Abmessungen der metallisierten Durchkontaktierung (7) abgestimmt sind, dass der elastische Einpressbereich (12) eine Querkraft (Fq) auf die metallisierte Durchkontaktierung (7) erzeugt, welche kleiner als 25N/mm² ist.

8. Elektrische Kontaktieranordnung (1) nach Anspruch 6 oder 7, wobei die zweite Kontaktschicht (8.1) der metallisierten Durchkontaktierung (7) Kupfer aufweist.

9. Verfahren zum Fügen eines Einpresspins (10), welcher nach zumindest einem der Ansprüche 1 bis 5 ausgeführt ist, und einer metallisierten Durchkontaktierung (7), welche in ein Loch (5) einer Leiterplatte (3) eingebracht ist, wobei der Einpresspin (10) in die metallisierte Durchkontaktierung (7) eingeschoben wird, bis eine gewünschte Tiefe erreicht ist, wobei die reaktive Multischicht (14.1) der Beschichtung (14) des Einpresspins (10) durch einen Energieimpuls aktiviert wird, welcher eine exothermen Reaktion der reaktiven Multischicht (14.1) auslöst, wobei durch die exotherme Reaktion erzeugte Wärme die benachbarte erste Kontaktschicht (14.2) des Einpresspins (10) und die zweite Kontaktschicht (8.1) der metallisierten Durchkontaktierung (7) aufschmelzt und miteinander zu einer materialschlüssigen Verbindung (9) verschweißt.

10. Verfahren nach Anspruch 9, wobei der Energieimpuls gezielt in eine Spitze (16) des in die metallisierten Durchkontaktierung (7) eingeschobenen Einpresspins (10) eingeleitet wird, welche aus der metallisierten Durchkontaktierung (7) herausragt.

11. Verfahren nach Anspruch 9 oder 10, wobei der Energieimpuls als Laserimpuls (ZI) oder elektrischer Impuls erzeugt wird.

## Claims

1. Press-in pin (10) for an electrical contact-making arrangement (1), comprising an elastic press-in region (12) and an electrically conductive coating (14) which comprises a reactive multilayer (14.1) which is applied to the press-in pin (10) and a first contact layer (14.2) which is applied to the reactive multilayer (14.1), **characterized in that** the electrically conductive coating (14) is tin-free and the applied reactive multilayer (14.1) can be activated by an energy pulse which triggers an exothermic reaction, wherein heat which is generated by the exothermic reaction can melt the adjacent first contact layer (14.2) of the press-in pin (10) and the second contact layer (8.1) of the metallized plated-through hole (7) and weld said first contact layer and said second contact layer to one another to form an integrally joined connection (9).

2. Press-in pin (10) according to Claim 1, wherein the reactive multilayer (14.1) is applied to an effective press-in length of the elastic press-in region (12).

3. Press-in pin (10) according to Claim 1 or 2, wherein the reactive multilayer (14.1) is constructed from at least two different metal materials which are deposited alternately on the press-in pin (10).

4. Press-in pin (10) according to Claim 3, wherein the reactive multilayer (14.1) contains aluminium as the first metal material and nickel as the second metal material.

5. Press-in pin (10) according to one of Claims 1 to 4, wherein copper is applied as the first contact layer (14.2).

6. Electrical contact-making arrangement (1) comprising a press-in pin (10), which has an elastic press-in region (12) and an electrically conductive coating (14), and a metallized plated-through hole (7), which is inserted into a hole (5) in a printed circuit board (3) and forms a contact area (8) for the elastic press-in region (12) and the electrically conductive coating (14), wherein the press-in pin (10) is pushed into the metallized plated-through hole (7) and an integrally joined connection (9) is formed between a first contact layer (14.2) of the press-in pin (10) and a second contact layer (8.1) of the metallized plated-through hole (7), wherein the press-in pin (10) is designed according to at least one of Claims 1 to 5, wherein the integrally joined connection (9) is produced on account of an exothermic reaction of the activated reactive multilayer (14.1)

7. Electrical contact-making arrangement (1) according to Claim 6, wherein dimensions and spring properties of the elastic press-in region (12) of the press-in pin (10) are matched to dimensions of the metallized plated-through hole (7) such that the elastic press-in region (12) generates a lateral force (Fq) on the metallized plated-through hole (7) which is less than 25 N/mm².

8. Electrical contact-making arrangement (1) according to Claim 6 or 7, wherein the second contact layer (8.1) of the metallized plated-through hole (7) contains copper.

9. Method for joining a press-in pin (10), which is designed according to at least one of Claims 1 to 5, and a metallized plated-through hole (7) which is inserted into a hole (5) in a printed circuit board (3), wherein the press-in pin (10) is pushed into the metallized plated-through hole (7) until a desired depth is reached, wherein the reactive multilayer (14.1) of the coating (14) of the press-in pin (10) is activated by an energy pulse which triggers an exothermic reaction of the reactive multilayer (14.1), wherein heat which is generated by the exothermic reaction melts the adjacent first contact layer (14.2) of the press-in pin (10) and the second contact layer (8.1) of the metallized plated-through hole (7) and welds said first contact layer and said second contact layer to one another to form an integrally joined connection (9).

10. Method according to Claim 9, wherein the energy pulse is introduced in a targeted manner into a tip (16) of the press-in pin (10) which is pushed into the metallized plated-through hole (7), said tip protruding out of the metallized plated-through hole (7).

11. Method according to Claim 9 or 10, wherein the energy pulse is generated as a laser pulse (ZI) or an electrical pulse.

## Revendications

1. Broche à enfoncer (10) pour un agencement de mise en contact électrique (1), comprenant une zone d'enfoncement élastique (12) et un revêtement électriquement conducteur (14), lequel comporte une multicouche réactive (14.1) appliquée sur la broche à enfoncer (10) et une première couche de contact (14.2) appliquée sur la multicouche réactive (14.1), **caractérisée en ce que** le revêtement électriquement conducteur (14) est réalisé sans étain et la multicouche réactive (14.1) appliquée peut être activée par une impulsion d'énergie déclenchant une réaction exothermique, la chaleur générée par la réaction exothermique pouvant faire fondre la première couche de contact (14.2) voisine de la broche à enfoncer (10) et la deuxième couche de contact (8.1) d'un contact traversant métallisé (7) et les souder entre elles pour former une liaison par fusion de matières (9).

2. Broche à enfoncer (10) selon la revendication 1, la multicouche réactive (14.1) étant appliquée sur une longueur d'insertion effective de la zone d'enfoncement élastique (12).

3. Broche à enfoncer (10) selon la revendication 1 ou 2, la multicouche réactive (14.1) étant constituée d'au moins deux matériaux métalliques différents, qui sont déposés en alternance sur la broche à enfoncer (10).

4. Broche à enfoncer (10) selon la revendication 3, la multicouche réactive (14.1) possédant de l'aluminium comme premier matériau métallique et du nickel comme deuxième matériau métallique.

5. Broche à enfoncer (10) selon l'une des revendications 1 à 4, du cuivre étant appliqué en tant que première couche de contact (14.2).

6. Agencement de mise en contact électrique (1) comprenant une broche à enfoncer (10), laquelle possède présente une zone d'enfoncement élastique (12) et un revêtement électriquement conducteur (14), et un contact traversant métallisé (7), lequel est introduit dans un trou (5) d'une carte à circuit imprimé (3) et forme une surface de contact (8) pour la zone d'enfoncement élastique (12) et le revêtement électriquement conducteur (14), la broche à enfoncer (10) étant insérée dans le contact traversant métallisé (7) et une liaison par fusion de matières (9) étant formée entre une première couche de contact (14. 2) de la broche à enfoncer (10) et une deuxième couche de contact (8.1) du contact traversant métallisé (7), la broche à enfoncer (10) étant réalisée selon au moins l'une des revendications 1 à 5, la liaison par fusion de matières (9) étant produite en raison d'une réaction exothermique de la multicouche réactive activée (14.1).

7. Agencement de mise en contact électrique (1) selon la revendication 6, les dimensions et les propriétés élastiques de la zone d'enfoncement élastique (12) de la broche à enfoncer (10) étant adaptées aux dimensions du contact traversant métallisé (7) de telle sorte que la zone d'enfoncement élastique (12) génère une force transversale (Fq) sur le contact traversant métallisé (7) qui est inférieure à 25 N/mm².

8. Agencement de mise en contact électrique (1) selon la revendication 6 ou 7, la deuxième couche de contact (8.1) du contact traversant métallisé (7) possédant du cuivre.

9. Procédé d'assemblage d'une broche à enfoncer (10), qui est réalisée selon au moins l'une des revendications 1 à 5, et d'un contact traversant métallisé (7), qui est introduit dans un trou (5) d'une carte à circuit imprimé (3), la broche à enfoncer (10) étant insérée dans le contact traversant métallisé (7) jusqu'à ce qu'une profondeur souhaitée soit atteinte, la multicouche réactive (14. 1) du revêtement (14) de la broche à enfoncer (10) étant activée par une impulsion d'énergie qui déclenche une réaction exothermique de la multicouche réactive (14.1), la chaleur produite par la réaction exothermique faisant fondre la première couche de contact (14.2) voisine de la broche à enfoncer (10) et la deuxième couche de contact (8.1) du contact traversant métallisé (7) et les soudant l'une à l'autre pour former une liaison par fusion de matières (9).

10. Procédé selon la revendication 9, l'impulsion d'énergie étant injectée de manière ciblée dans une pointe (16) de la broche à enfoncer (10) insérée dans le contact traversant métallisé (7), laquelle fait saillie du contact traversant métallisé (7).

11. Procédé selon la revendication 9 ou 10, l'impulsion d'énergie étant générée sous la forme d'une impulsion laser (ZI) ou d'une impulsion électrique.
